# EUROPEAN PATENT APPLICATION

(11) **EP 2 615 062 A2**
(43) Date of publication of application: **17.07.2013**
(21) Application number: 12158392.6
(22) Date of filing: 07.03.2012
(51) Int. Cl.: C01B 31/02, H01L 51/30, H01L 51/00

(54) **Method of growing carbon nanotubes laterally, and lateral interconnections and field effect transistor using the same**

(30) Priority: 16.01.2012 KR 20120004946; 14.02.2012 KR 20120014561
(71) Applicant: Industry-Academic Cooperation Foundation at NamSeoul University, Cheonan-si, Chungcheongnam-do 331-707 (KR)
(72) Inventor: Lee, Sun-Woo, 405-771 Incheon (KR); Lee, Boong-Joo, 420-020 Gyeonggi-do (KR)
(74) Representative: Nederlandsch Octrooibureau

(57) **Abstract**

Provided are a method of growing carbon nanotubes laterally, including forming catalyst dots to grow carbon nanotubes on a substrate, forming a sacrificial layer including a plurality of nanochannels including regions having the catalyst dots formed therein, and growing carbon nanotubes through the nanochannels, and a field effect transistor using the method.

## Description

### CROSS-REFERENCE TO RELATED APPLICATIONS

This application claims the priority of Korean Patent Application No. 10-2012-0004946 filed on January 16, 2012 and Korean Patent Application No. 10-2012-0014561 filed on February 14, 2012, in the Korean Intellectual Property Office, the disclosure of which is incorporated herein by reference.

### BACKGROUND OF THE INVENTION

### Field of the Invention

The present invention relates to a method of growing carbon nanotubes laterally, and lateral interconnections and a field effect transistor using the same, and more particularly, to a method of growing carbon nanotubes laterally by using a plurality of nanochannels including regions in which catalyst dots are formed, and lateral interconnections and a field effect transistor formed by using the same.

### Description of the Related Art

A carbon nanotube (CNT) has a cylindrical shape formed by cylindrically winding a graphite plate, and more particularly, has a one-dimensional quantum wire structure, in which carbon atoms connected by hexagonal rings form a long tube shaped structure having a diameter in a range of a few nm to a few tens of nm and a length range of a few µm to a few hundreds of µm.

Such carbon nanotubes have excellent mechanical and chemical properties and have unusual electrical properties such as a one-dimensional quantum transport phenomenon. In particular, carbon nanotubes not only have high strength but may also be bent without structural failure, have resilience in restoring their original shape, and have characteristics of exhibiting almost no abrasion or damage over a prolonged period of use. Also, since carbon nanotubes have a very large diameter-to-length ratio, a structural anisotropy is high, and since carbon nanotubes have characteristics in which electrical properties thereof may change according to the shape, structure, and diameter thereof, the carbon nanotubes may accordingly have conducting or semiconducting properties. In addition, since carbon nanotubes have high thermal conductivity, high electron emission properties, and excellent chemical reactivity, applications for carbon nanotubes within a range of industrial fields can be expected.

One possible application of such carbon nanotubes in the field of semiconductors is in replacing metal interconnections. A development of a reproducible manufacturing process for carbon nanotubes must first be implemented in order to realize this possibility, tough. However, since a method of disposing carbon nanotubes in desired positions by manipulating carbon nanotubes one by one after the manufacturing thereof may be chosen at the current level of technique, the realization of an electronic device or highly integrated device may be difficult.

Also, at the current level of carbon nanotube manufacturing techniques, a main technique of synthesizing carbon nanotubes features vertically growing carbon nanotubes, and this technique is for growing the nanotubes on a substrate with catalyst patterns formed in a direction perpendicular to a surface thereof. However, even in the case that the vertically grown carbon nanotubes may have excellent alignment, uniform control of the length and spacing thereof may be difficult. Further, it may be difficult to apply the vertically grown carbon nanotubes to a semiconductor manufacturing process.

### SUMMARY OF THE INVENTION

An aspect of the present invention provides a method of growing carbon nanotubes laterally, which has reproducibility, is applicable to a highly integrated device, may uniformly control the length and spacing thereof, and is easily applicable to a semiconductor manufacturing process, and lateral interconnections and a field effect transistor using the method.

According to an aspect of the present invention, there is provided a method of growing carbon nanotubes laterally, including: forming catalyst dots to grow carbon nanotubes on a substrate; forming a sacrificial layer including a plurality of nanochannels including regions having the catalyst dots formed therein; and growing carbon nanotubes through the nanochannels.

According to another aspect of the present invention, there are provided lateral interconnections including a plurality of interconnections arranged in parallel, wherein the interconnections are formed of carbon nanotubes grown laterally by using the method of growing carbon nanotubes laterally.

According to another aspect of the present invention, there is provided a method of manufacturing a field effect transistor (FET) including forming electrodes at both ends of carbon nanotubes grown laterally by using the method of growing carbon nanotubes laterally and removing metallic carbon nanotubes by supplying a current through the electrodes.

According to another aspect of the present invention, there is provided a field effect transistor (FET) including a plurality of interconnections arranged in parallel, wherein the interconnections are formed of carbon nanotubes grown laterally by using the method of growing carbon nanotubes laterally.

In addition, the foregoing means to solve the objects do not list all characteristics of the present invention. Various characteristics of the present invention and the advantages and effects according thereto may be understood in more detail with reference to the following specific embodiments.

### BRIEF DESCRIPTION OF THE DRAWINGS

The above and other aspects, features and other advantages of the present invention will be more clearly understood from the following detailed description taken in conjunction with the accompanying drawings, in which:

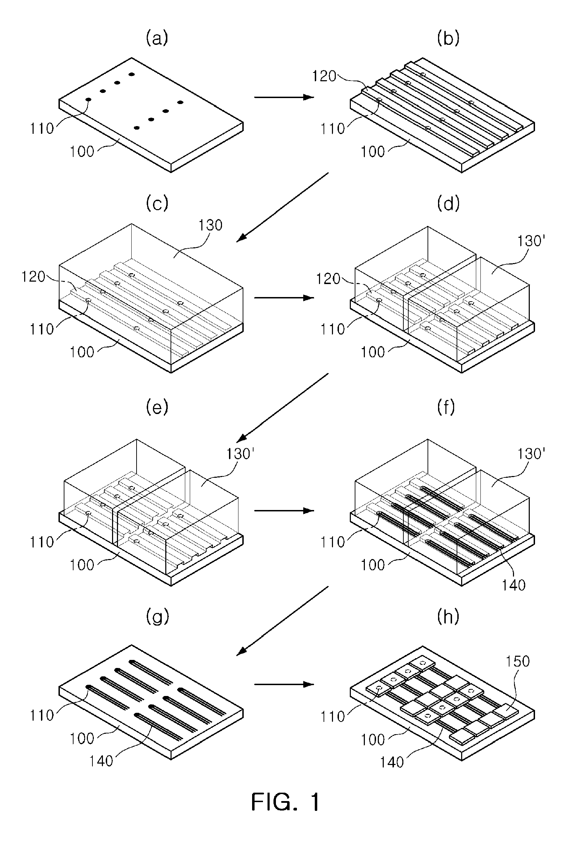

FIG. 1 illustrates a method of growing carbon nanotubes laterally, according to an embodiment of the present invention.

### DETAILED DESCRIPTION OF THE PREFERRED EMBODIMENT

Hereinafter, the present invention will be described in more detail with reference to the accompanying drawings.

As a result of a significant amount of research conducted in order to develop lateral interconnections, which may replace metal interconnections in a semiconductor device, are reproducible, and may have the length and spacing thereof uniformly controlled, and a transistor, which may be easily applied to a semiconductor manufacturing process and may be miniaturized and have high performance, by using carbon nanotubes, the inventors of the present invention found a method of growing carbon nanotubes by using nanochannels and thus completed the present invention.

That is, since the inventors of the present invention developed a method of forming a plurality of nanochannels and accordingly growing carbon nanotubes from catalyst dots, difficulties in forming lateral interconnections due to vertical growth characteristics of the carbon nanotubes are significantly improved, and the inventors thus completed the present invention related to a method of growing carbon nanotubes laterally which has excellent reproducibility and may easily control the length and spacing thereof.

Also, the inventors have confirmed that lateral interconnections and field effect transistor (FET) may be manufactured by using the foregoing method of growing carbon nanotubes laterally and a semiconductor manufacturing process may be significantly simplified and productivity may be greatly improved when the method is used.

According to an aspect of the present invention, there is provided a method of growing carbon nanotubes laterally, including: forming catalyst dots to grow carbon nanotubes on a substrate; forming a sacrificial layer including a plurality of nanochannels including regions having the catalyst dots formed therein; and growing carbon nanotubes through the nanochannels.

Hereinafter, the method of growing carbon nanotubes laterally will be described in more detail with reference to FIG. 1.

First, catalyst dots 110 to grow carbon nanotubes are formed on a substrate 100. At this time, the catalyst dots 110 may be formed in an appropriate amount and with appropriate spacing in consideration of the number and spacing of interconnections to be formed. For example, the catalyst dots 110 may be aligned in a single direction at a predetermined spacing on the substrate 100. The catalyst dots 110 aligned in two rows are shown in FIG. 1(a), but an embodiment of the present invention is not limited thereto. For example, the plurality of catalysts dots 110 may be arranged so as to include the catalyst dots 110 within a spacing range of about 10 nm to 100 nm. The foregoing spacing between the catalyst dots 110 may be changed according to the intended spacing of the interconnections to be formed.

Also, the catalyst dots 110 may be formed to have a diameter range of 0.1 nm to 5 nm, 0.5 nm to 3 nm, or 1 nm to 4 nm. Since a diameter of the carbon nanotubes is determined according to the size of the catalyst dots 110, the diameter of the catalysts may be decreased to be as small as possible in order to achieve fine interconnections.

At this time, any method well known in the art may be used, without limitation, as a method of forming the catalyst dots 110, and for example, the method may be photolithography. The method of forming the catalyst dots 110 by photolithography, for example, may be performed through a method, in which the substrate 100 is coated with a photoresist, catalyst dot 110 forming positions are selectively exposed by using a mask and then etched, and catalysts are deposited through physical vapor deposition (PVD) or chemical vapor deposition (CVD).

Herein, any substrate well known in the art may be used as the substrate 100 without limitation, and for example, a silicon substrate may be used.

Also, an oxide layer as an insulation layer is formed on the substrate 100, and any oxide layer well known in the art may be used as the oxide layer without limitation, and for example, a silicon oxide (SiO₂) layer may be used. At this time, the forming of the oxide layer may be performed by a method well known in the art and for example, may be a pyrolytic deposition of a silicon precursor containing oxygen or a silicon precursor in an oxygen atmosphere.

Meanwhile, any catalyst dot well known in the art may be used as the catalyst without limitation, and for example, the catalyst dot may be one or more selected from the group consisting of nickel (Ni), cobalt (Co), iron (Fe), palladium (Pd), gold (Au), and an alloy and an organic material thereof.

Next, a sacrificial layer including a plurality of nanochannels, including regions in which the catalyst dots 110 formed, is formed. At this time, the forming of the sacrificial layer, for example, may be performed by including forming a first sacrificial layer 120 to form a plurality of nanochannels including regions with the catalyst dots 110 formed therein, forming a second sacrificial layer 130 on the first sacrificial layer 120, and removing the first sacrificial layer 120 to form nanochannels.

Herein, any method well known in the art may be used without limitation in the forming of the first sacrificial layer 120 to form a plurality of nanochannels including regions with the catalyst dots 110 formed therein, and for example, the forming of the first sacrificial layer 120 may be undertaken by photolithography using a photoresist or a pattern transfer method using printing or a stamp. In particular, in the present invention, the forming of the first sacrificial layer 120 may be performed by photolithography in terms of contamination prevention.

At this time, since the first sacrificial layer 120 is to form a plurality of nanochannels, the first sacrificial layer 120 may be formed in various configurations according to the shape of interconnections to be formed. For example, the first sacrificial layer 120 may be formed in a stripe shape as shown in FIG. 1 (b), but the shape thereof is not limited thereto. Also, the first sacrificial layer 120 may include one or more of the catalyst dots 110 and the width and spacing thereof may be adjusted according to the catalyst dots 110.

Meanwhile, the first sacrificial layer 120 may be a material selectively removable with respect to the second sacrificial layer 130 which will be described below and for example, may be a photoresist or an organic material including the photoresist. A commercial product may be used as the photoresist, and for example, AZ1512 or AZ9260 (AZ Electric Materials Co.) may be used, but the photoresist is not limited thereto.

Next, as shown in FIG. 1(c), forming a second sacrificial layer 130 on the first sacrificial layer 120 may be performed. Any method well known in the art may be used as a method of forming the second sacrificial layer 130 without limitation, and for example, the forming of the second sacrificial layer 130 may be performed by chemical vapor deposition (CVD), thermal chemical vapor deposition (thermal CVD), plasma enhanced chemical vapor deposition (PECVD), physical vapor deposition (PVD), thermal evaporation, or sputtering. In the present invention, the method of forming the second sacrificial layer 130 may be performed by PECVD for the ease of processing.

Herein, any material selectively removable with respect to the oxide layer formed on the substrate 100 may be used as the second sacrificial layer 130 without limitation, and for example, the second sacrificial layer 130 may be one or more selected from the group consisting of Si₃N₄, SiGe, or a combination thereof. In particular, in the present invention, the second sacrificial layer 130 may be Si₃N₄ which is easily selectively removable with respect to the first sacrificial layer 120.

Next, removing the first sacrificial layer 120 after the forming of the second sacrificial layer 130 to form nanochannels may be performed. At this time, any method well known in the art may be used as a method of removing the first sacrificial layer 120 without limitation, and for example, the removing of the first sacrificial layer 120 may be performed by a method of removal through being dissolved in an organic solvent which may remove an organic material such as a photoresist. At this time, any etchant used to remove a photoresist may be used as the organic solvent without limitation, and for example, the first sacrificial layer 120 may be removed by using acetone. FIG. 1(e) illustrates a state in which the first sacrificial layer 120 is removed by the foregoing method such that nanochannels are formed.

Selectivity between the first sacrificial layer 120 and the second sacrificial layer 130 is numerically 100 : 1 or more, and the selectivity is a ratio of etching rates between two or more materials etched with a solvent. The etching rate ratio of 100 : 1 or more described in the present specification denotes that an etching rate of the second sacrificial layer 130 is 1 when an etching rate of the first sacrificial layer 120 is 100. That is, the first sacrificial layer 120 is dissolved by the solvent, while the second sacrificial layer 130 is only slightly dissolved.

Meanwhile, the forming of the second sacrificial layer 130 may further include patterning the second sacrificial layer 130 after the forming of the second sacrificial layer 130 on the first sacrificial layer 120 as needed, but not necessarily so. Herein, a method of patterning the second sacrificial layer 130 may be appropriately adjusted as needed and any method well known in the art may be used without limitation. For example, the method of patterning the second sacrificial layer 130 may be performed by photolithography. Since a growth length of carbon nanotubes may be controlled when the second sacrificial layer 130 is patterned as above, an interconnect length may be adjusted. FIG. 1(d) illustrates an example of a second sacrificial layer 130' patterned by the foregoing method.

In the method of growing carbon nanotubes laterally, according to the present invention, the forming of the catalyst dots and the forming of the sacrificial layer are performed by the foregoing methods, and the growing of the carbon nanotubes through the nanochannels is then performed. Herein, any method well known in the art may be used without limitation as the method of growing the carbon nanotubes, and for example, the growing of the carbon nanotubes may be performed by chemical vapor deposition, thermal chemical vapor deposition, plasma enhanced chemical vapor deposition, catalyst thermal reduction, or hot-filament vapor deposition.

Selectively, removing the sacrificial layer may be further included after the growing of the carbon nanotubes. Any method well known in the art may be used for the removal of the sacrificial layer without limitation, and for example, the removing of the sacrificial layer may be performed by a method of removing the second sacrificial layer 130 by immersion in a phosphoric acid (H₃PO₄) solution.

According to the method of growing carbon nanotubes laterally of the present invention, undertaken in the foregoing method, difficulties in forming lateral interconnections using carbon nanotubes may be significantly improved.

According to another aspect of the present invention, there are provided lateral interconnections including a plurality of interconnections arranged in parallel, wherein the interconnections are formed of carbon nanotubes grown laterally by using the method of growing carbon nanotubes laterally.

In lateral interconnections 140 of the present invention, the carbon nanotubes may be multi-walled. Herein, the multi-walled carbon nanotubes denote that multilayered carbon nanotubes exist in concentric circles. Since such multi-walled carbon nanotubes have very high electrical conductivity and excellent bond strength, a tolerance with respect to electromigration (EM) may be very high.

Also, the lateral interconnections of the interconnections may have a width range of 1 nm to 10 µm, 2 nm to 30 nm, 5 nm to 80 nm, or 50 nm to 1 µm.

Further, the lateral interconnection of the interconnections may have a height range of 1 nm to 1 µm, 2 nm to 10 nm, 5 nm to 50 nm, or 20 nm to 100 nm.

The lateral interconnection of the interconnections may have a spacing range of 1 nm to 1 mm, 5 nm to 50 nm, 10 nm to 100 nm, or 80 nm to 1 µm.

In the present invention, when the width, height, and spacing of the lateral interconnections satisfy the foregoing value ranges, the lateral interconnections may be variously used in a local region, in which interconnections having a width, height, or spacing range of a few nm to a few tens of nm are required, and a global region, in which interconnections having a width, height, or spacing range of few hundreds of nm to a few µm are required.

A highly integrated device may be realized because the lateral interconnections according to the present invention are formed of carbon nanotubes and the length and spacing thereof may be uniformly controlled, repeatability may be obtained, and replacement of metal interconnections in semiconductor design may be possible.

According to another aspect of the present invention, there is provided a method of manufacturing a field effect transistor (FET) including forming electrodes at both ends of carbon nanotubes grown laterally by using the method of growing carbon nanotubes laterally and removing metallic carbon nanotubes by supplying a current through the electrodes.

At this time, any method well known in the art may be used without limitation for the forming of the electrodes 150, and for example, the forming of the electrodes 150 may be performed by chemical vapor deposition or physical vapor deposition.

Next, any method well known in the art may be used for the removing of the metallic carbon nanotubes by supplying a current through the electrodes without limitation, and for example, the removing of the metallic carbon nanotubes may be performed by a method, in which a power source is connected to the electrodes at both ends to supply a large current to such a degree that the carbon nanotubes may burn.

When the FET is manufactured by using the foregoing method, a miniaturized and highly integrated FET may be obtained because forming of semiconducting carbon nanotubes forming arrays may be possible due to selective and easy removal of the metallic carbon nanotubes.

According to another aspect of the present invention, there is provided a field effect transistor including a plurality of interconnections arranged in parallel, wherein the interconnections are formed of carbon nanotubes grown laterally by using the method of growing carbon nanotubes laterally, according to the present invention.

In the FET of the present invention, the carbon nanotubes may be single-walled. The single-walled carbon nanotubes are a mixture of metallic and semiconducting carbon nanotubes, and only the semiconducting carbon nanotubes must be selected and used when the single-walled carbon nanotubes are applied to a transistor. The semiconducting carbon nanotubes may have general characteristics of carbon nanotubes, excellent electrical conductivity and tolerance with respect to electromigration, as well as gating being possible.

Since a miniaturized and high-performance semiconductor may be manufactured when the FET according to the present invention is used and the method of the present invention may be easily applied to a semiconductor manufacturing process, simplification of processing may be possible and productivity may be significantly improved.

When a method of growing carbon nanotubes laterally, according to the present invention is used, difficulties in forming lateral interconnections due to vertical growth characteristics and interconnection resistance of carbon nanotubes may be resolved, and the method may be reproducibly applied to a highly integrated device. Also, lateral interconnections formed by carbon nanotubes, which may replace metal interconnections of a semiconductor device, may be provided.

Also, when the method of growing carbon nanotubes laterally, according to the present invention is used, it is advantageous in manufacturing of a micro-device because interconnection length and spacing may be easily controlled, productivity may be improved by simplifying a manufacturing process through easy application to a semiconductor manufacturing process, and a field effect transistor having miniaturized and high-performance carbon nanotubes may be provided.

Further, when a semiconductor is manufactured by using the foregoing lateral interconnections and field effect transistors, high economic efficiency may be achieved because a typical scope of semiconductor limited to a memory field may be expanded to a non-memory field.

While the present invention has been shown and described in connection with the exemplary embodiments, it will be apparent to those skilled in the art that modifications and variations can be made without departing from the spirit and scope of the invention as defined by the appended claims.

## Claims

1. A method of growing carbon nanotubes laterally, the method comprising:
forming catalyst dots to grow carbon nanotubes on a substrate;
forming a sacrificial layer including a plurality of nanochannels including regions having the catalyst dots formed therein; and
growing carbon nanotubes through the nanochannels.

2. The method of claim 1, wherein the forming of the sacrificial layer comprises:
forming a first sacrificial layer to form a plurality of nanochannels including regions having the catalyst dots formed therein;
forming a second sacrificial layer on the first sacrificial layer; and
removing the first sacrificial layer to form nanochannels.

3. The method of claim 2, further comprising patterning the second sacrificial layer after the forming of the second sacrificial layer.

4. The method of claim 1, wherein the growing of the carbon nanotubes is performed by chemical vapor deposition, thermal chemical vapor deposition, plasma enhanced chemical vapor deposition, catalyst thermal reduction, or hot-filament vapor deposition.

5. The method of claim 1, further comprising removing the sacrificial layer after the growing of the carbon nanotubes.

6. The method of claim 2, wherein the first sacrificial layer is formed of a photoresist or an organic material including the photoresist.

7. The method of claim 2, wherein the second sacrificial layer is formed of Si₃N₄, SiGe, or a combination thereof.

8. Lateral interconnections comprising a plurality of interconnections arranged in parallel, wherein the interconnections are formed of carbon nanotubes grown laterally by using any one of claims 1 to 7.

9. The lateral interconnections of claim 8, wherein the carbon nanotubes are multi-walled.

10. The lateral interconnections of claim 8, wherein the interconnections have a width range of 1 nm to 10 µm.

11. The lateral interconnections of claim 8, wherein the interconnections have a height range of 1 nm to 1 µm.

12. The lateral interconnections of claim 8, wherein the interconnections have a spacing range of 1 nm to 1 mm.

13. A method of manufacturing a field effect transistor (FET), the method comprising:
forming electrodes at both ends of carbon nanotubes grown laterally by using the method of growing carbon nanotubes laterally of any one of claims 1 to 7; and
removing metallic carbon nanotubes by supplying a current through the electrodes.

14. A field effect transistor (FET) comprising a plurality of interconnections arranged in parallel, wherein the interconnections are formed of carbon nanotubes grown laterally by using any one of claims 1 to 7.

15. The field effect transistor (FET) of claim 14, wherein the carbon nanotubes are single-walled.
